# EUROPEAN PATENT APPLICATION

(11) **EP 1 063 698 A2**
(43) Date of publication of application: **27.12.2000**
(21) Application number: 00203093.0
(22) Date of filing: 09.02.1996
(51) Int. Cl.: H01L 21/8242

(54) **Method of forming a dram bit line contact**

(30) Priority: 22.02.1995 US 394545; 22.02.1995 US 394546
(62) Divisional of application: 96906367.6
(71) Applicant: MICRON TECHNOLOGY, INC., Boise, ID 83706-9632 (US)
(72) Inventor: Dennison, Charles H., Meridian, Idaho 83642 (US); Jost, Mark, Boise, Idaho 83712 (US); Parekh, Kunal, Boise, Idaho 83712 (US)
(74) Representative: Smith, Sarah Elizabeth

(57) **Abstract**

A method of forming a capacitor opening (32) is described, the method comprising the following steps: forming an electrically conductive layer (90) over an insulating material layer (28); and forming a capacitor opening through the electrically conductive layer and into the insulating material layer. After forming the capacitor opening, the electrically conductive layer is removed from over the insulating material layer. The electrically conductive layer is polished to remove the electrically conductive layer from over the insulating material layer. A bit line contact opening (34) is formed within the insulating material layer, the electrically conductive layer within the bit line contact opening ultimately forming a bit line plug (90).

## Description

### Technical Field

This invention relates generally so formation of a bit line over capacitor arrays of memory cells.

### Background Art

As DRAMs increase in memory cell density, there is a continuing challenge to maintain sufficiently high storage capacitance despite decreasing cell area. Additionally, there is a continuing goal to further decrease cell area. The principal way of increasing cell capacitance is through cell structure techniques. Such techniques include three-dimensional cell capacitors, such as trenched or stacked capacitors.

Conventional stacked capacitor DRAM arrays utilize either a buried bit line or a non-buried bit line construction. With buried bit line constructions, bit lines are provided in close vertical proximity to the bit line contacts of the memory cell field effect transistors (FETs), with the cell capacitors being formed horizontally over the top of the word lines and bit lines. With non-buried bit line constructions, deep vertical contacts are made through a thick insulating layer to the cell FETs, with the capacitor constructions being provided over the word lines and beneath the bit lines. Such non-buried bit line constructions are also referred to as "capacitor-under-bit line" or "bit line-over-capacitor" constructions, and are the subject of this invention.

### Brief Description of the Drawings

Preferred embodiments of the invention are described below with reference to the following accompanying drawings.
Fig. 1 is a diagrammatic sectional view of a semiconductor wafer fragment at one processing step in accordance with the invention.
Fig. 2 is a view of the Fig. 1 wafer taken at a step subsequent to that shown by Fig. 1.
Fig. 3 is a view of the Fig. 1 wafer taken at a step subsequent to that shown by Fig. 2.
Fig. 4 is a view of the Fig. 1 wafer taken at a step subsequent to that shown by Fig. 3.
Fig. 5 is a view of the Fig. 1 wafer taken at a step subsequent to that shown by Fig. 4.
Fig. 6 is a view of the Fig. 1 wafer taken at a step subsequent to that shown by Fig. 5.
Fig. 7 is a view of the Fig. 1 wafer taken at a step subsequent to that shown by Fig. 6.
Fig. 8 is a view of the Fig. 1 wafer taken at a step subsequent to that shown by Fig. 7.
Fig. 9 is a view of the Fig. 1 wafer taken at a step subsequent to that shown by Fig. 8.
Fig. 10 is a diagrammatic sectional view of an alternate embodiment semiconductor wafer fragment at one alternate processing step in accordance with the invention.
Fig. 11 is a view of the Fig. 10 wafer taken at a step subsequent to that shown by Fig. 10.
Fig. 12 is a view of the Fig. 10 wafer taken at a step subsequent to that shown by Fig. 11.
Fig. 13 is a diagrammatic sectional view taken through line 13-13 in Fig. 12.
Fig. 14 is a diagrammatic sectional view taken through line 14-14 in Fig. 12.
Fig. 15 is a diagrammatic sectional view of an alternate embodiment semiconductor wafer fragment at one alternate processing step in accordance with the invention.
Fig. 16 is a view of the Fig. 15 wafer taken at a step subsequent to that shown by Fig. 15.
Fig. 17 is a view of the Fig. 15 wafer taken at a step subsequent to that shown by Fig. 16.
Fig. 18 is a view of the Fig. 15 wafer taken at a step subsequent to that shown by Fig. 17.

### Best Modes for Carrying Out the Invention and Disclosure of Invention

In accordance with one aspect of the invention, a method of forming a bit line over capacitor array of memory cells comprises the following steps:
providing an array of substantially electrically isolated word lines atop a semiconductor wafer;
providing active areas about the word lines to define an array of memory cell FETs, the active areas being defined by a first active region for electrical connection with a memory cell capacitor and a second active region for electrical connection with a bit line;
providing a layer of electrically insulating material over the word lines and active regions, the layer of insulating material having an uppermost surface which is above the word lines;
providing first contact openings through the insulating material layer to the first active areas;
providing a second contact openings through the insulating material layer to the second active areas;
providing a first layer of electrically conductive material over the insulating material layer and within the first contact openings to electrically connect with the first active regions, the first layer being provided to a thickness which less than completely fills the first contact openings thereby leaving outwardly open first voids within the first contact openings;
providing a capacitor dielectric layer over the first layer and within the first voids of the first contact openings, the capacitor dielectric layer being provided to a thickness which less than completely fills the first voids thereby leaving outwardly open second voids within the first contact openings;
providing a second layer of electrically conductive material within the second voids of the first contact openings;
providing electrically conductive material within the second contact openings;
electrically isolating all electrically conductive material within the first contact openings from all electrically conductive material within the second contact openings;
providing a bit line insulating layer outwardly of the conductive material within the second contact opening;
patterning a bit contact opening through the bit line insulating layer to outwardly expose the electrically conductive material within the second contact opening; and
providing a patterned bit line in electrical communication with the outwardly exposed electrically conductive material within the second contact opening through the bit contact opening.

In accordance with another aspect of the invention, an integrated circuit comprises:
an elevationally inner electrically conductive node;
an elevationally outer electrically conductive node discrete from the inner electrically conductive node;
a dielectric insulating layer positioned intermediate the inner and outer nodes; and
an interconnecting plug extending through the insulating layer and connecting the inner and outer nodes in ohmic electrical connection, the interconnecting plug comprising an electrically conductive annular ring.

In accordance with yet another aspect of the invention, a semiconductor memory device comprises:
a semiconductor substrate;
a field effect transistor gate positioned outwardly of the semiconductor substrate;
opposing active areas formed within the semiconductor substrate on opposing sides of the gate;
a capacitor electrically connected with one of the active areas; the capacitor comprising an inner storage node, a capacitor dielectric layer, and an outer cell node; the inner storage node electrically connecting with the one active area and physically contacting the one active area;
a bit line;
a dielectric insulating layer positioned intermediate the bit line and the other active area; and
an electrically conductive bit line plug extending through the insulating layer to contact with the other active area and electrically interconnect the bit line with the other active area.

These and other aspects of the invention will be appreciated from the following description and concluding claims.

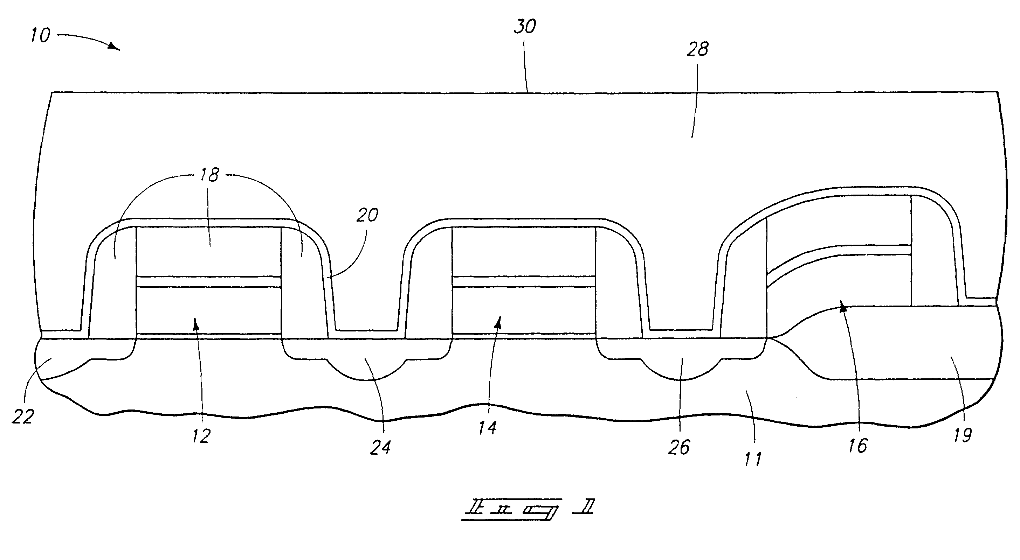

Referring first to Fig. 1, a semiconductor wafer fragment is indicated generally by reference numeral 10. Wafer 10 is defined in part by a bulk silicon semiconductive substrate 11, and has been provided with an array of substantially electrically isolated word lines, such as the illustrated word lines 12, 14 and 16. Such word lines are of a conventional construction having a lowermost gate oxide, a lower polysilicon layer, an overlying silicide layer such as tungsten silicide, and insulating caps and side insulating spacers 18. Such spacers and caps 18 preferably comprise an insulative nitride, such as Si₃N₄. A thin layer 20 of Si₃N₄ is provided atop the wafer to function as a diffusion barrier. Layer 20 has a thickness which is preferably from about 100 Angstroms to about 250 Angstroms.

Active areas are provided about the word lines, such as active regions 22, 24 and 26, to define an array of memory cell FETs. The discussion proceeds with reference to a FET formed using word line 14, which would be provided with a capacitor construction for definition of a single memory cell. Active region 26 defines a first active region for electrical connection with a memory cell capacitor (described below). Active region 24 defines a second active region for electrical connection with a bit line (described below). Field oxide 19 is provided, as shown.

A first insulating material layer 28 is provided over the word lines and active areas. An example material is borophosphosilicate glass (BPSG), with an example deposition thickness being between 6,000 and 20,000 Angstroms. Preferably as shown, layer 28 is subsequently planarized by chemical-mechanical polishing (CMP) to an elevation of from about 2,000 Angstroms to about 8,000 Angstroms above the word line nitride caps 18 which are positioned adjacent the active areas, as opposed to the word lines which are over the field oxide. Such provides a planarized upper surface 30 which is elevationally above the word lines. Alternately, layer 28 could be unpolished at this point in the process.

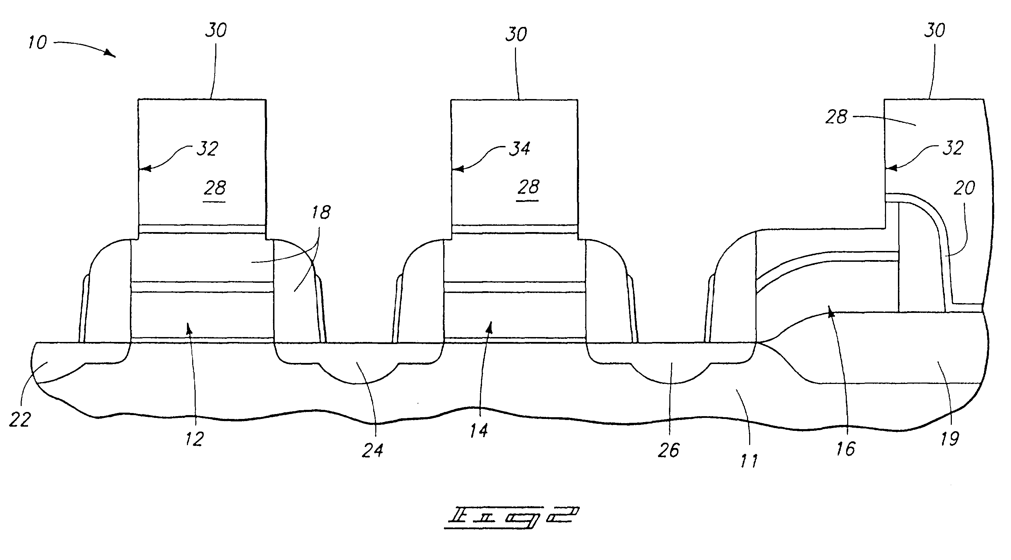

Referring to Fig. 2, a series of first contact openings 32 and second contact openings 34 are provided through first layer 28 to first and second active regions 26 and 24, respectively. Such would typically be formed by photomasking and dry chemical etching of BPSG selectively relative to nitride. An example etch chemistry would include CHF₃ and O₂ at low O₂ flow rate (i.e., less than 5% O₂ by volume in a CHF₃/O₂ mixture), or the combination of CF₄, Ar, CH₂F₂ and CHF₃. Thereafter, an etch of the wafer is conducted to etch nitride layer 20 selectively relative to underlying silicon substrate 11 to upwardly expose active regions 26 and 24. An example etch chemistry would include a combination of CHF₃ and CF₄. The principal purpose of barrier layer 20 is to prevent diffusion of boron or phosphorus atoms from BPSG layer 28 into active areas 24 and 26. Caps 18 are preferably comprised of nitride (Si₃N₄) and layer 28 comprised of oxide, such that the contact etch to produce first contacts 32 and 34 will stop relative to word line spacers and caps 18.

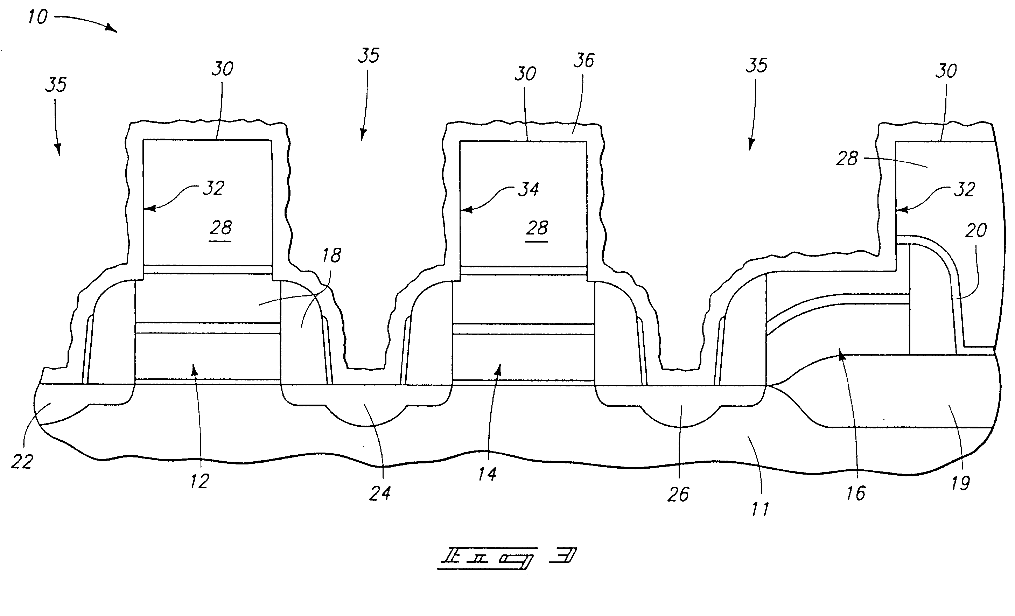

Referring to Fig. 3, a first layer 36 of electrically conductive material is provided over insulating material layer 28 to within first contact opening 32 and second contact opening 34 to electrically connect with first and second active regions 26 and 24, respectively. First layer 36 is deposited to a thickness which less than completely fills first contact opening 32 and second contact opening 34, thereby leaving outwardly open first voids 35 within the first and second contact openings. An example diameter for first contact opening 32 is 0.6 micron, while example dimensions for second contact opening 34 are 0.6 x 1.0 micron. In such instance, an example preferred thickness for layer 36 is 1000 Angstroms. An example and preferred material for layer 36 is hemispherical grain (HSG) polysilicon. Such can be provided by first depositing a 600 Angstroms thick *in situ* doped polysilicon layer, followed by deposition of undoped HSG poly. Subsequent heating inherent in wafer processing will effectively conductively dope the overlying HSG poly layer. Alternately, layer 36 can be provided by *in situ* arsenic doping of an entire HSG layer.

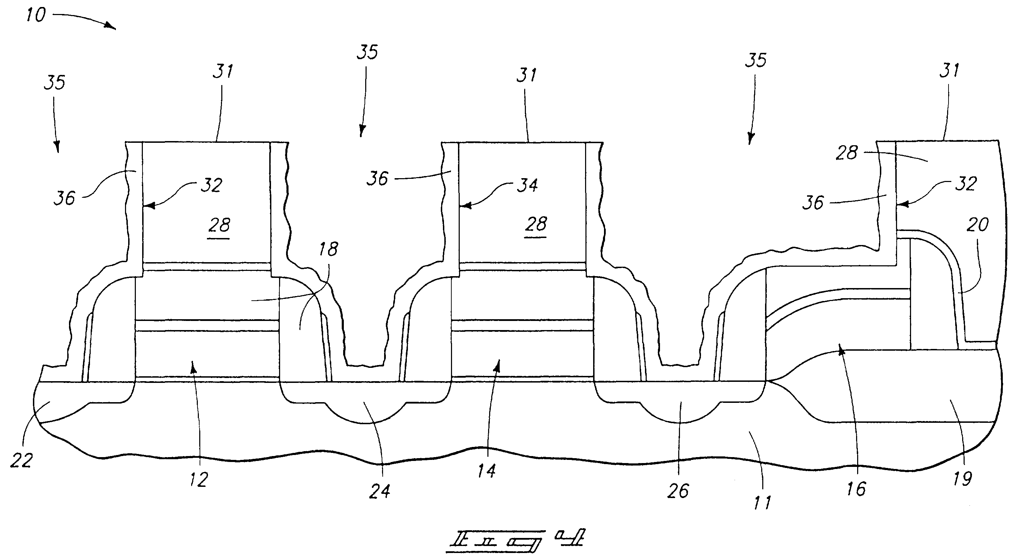

Referring to Fig. 4, wafer fragment 10 is planarized etched downwardly at least to former upper surface 30 (not shown) of insulating material 28 to remove conductive material 36 thereabove. This will isolate first layer conductive material 36 within first contact openings 32 from first layer conductive material 36 within second contact openings 34. Such planarized etching can be conducted by photoresist deposition and etchback, or by chemical-mechanical polishing. As shown, such planarized etching is conducted to a location which is slightly below former outer insulating layer 30, which in Fig. 4 is now designated with numeral 31.

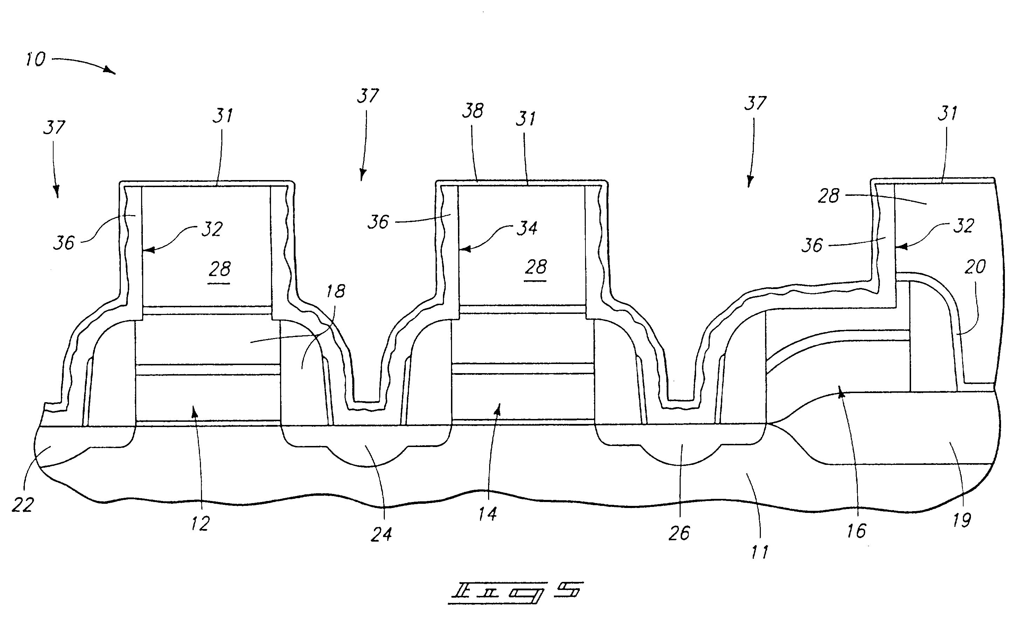

Referring to Fig. 5, a capacitor dielectric layer 38 is provided over patterned first conductive layer 36 and within first voids 35 of first contact openings 32 and second contact openings 34. Capacitor dielectric layer 38 is provided to a thickness which less than completely fills first voids 35, thereby leaving outwardly open second voids 37 within the first and second contact openings. Layer 38 preferably comprises an oxide-nitride-oxide (ONO) cell dielectric, with an example preferred total deposition thickness being 80 Angstroms. Other materials, such as T₂O₅ or barium strontium titanate, are also of course possible. Thus in this preferred described embodiment, the planarized etching step which isolates first conductive material layer 36 relative to the first and second contact openings is conducted prior to the step of providing capacitor dielectric layer 38.

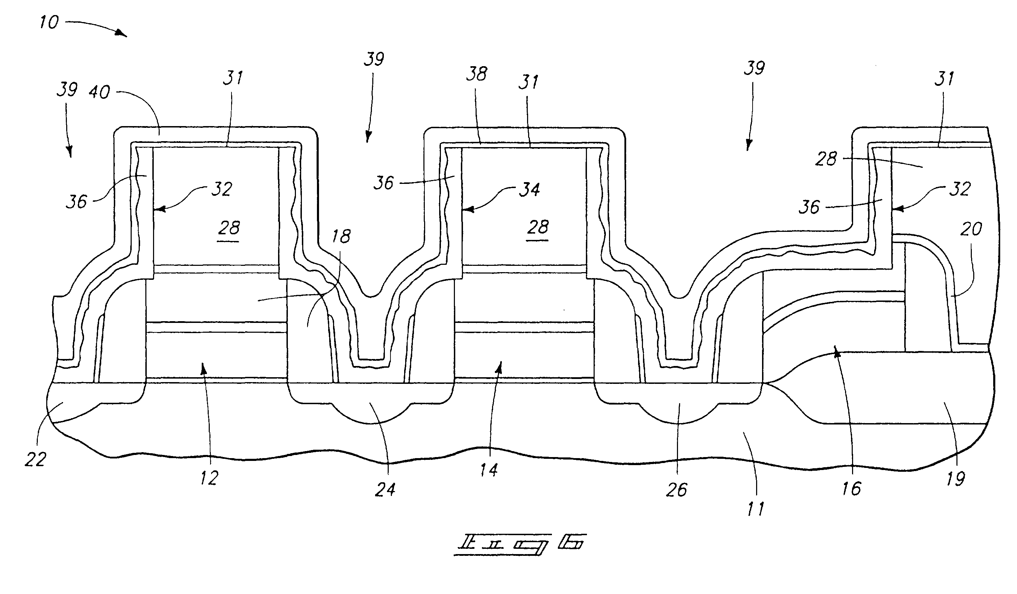

Referring to Fig. 6, a second layer 40 of electrically conductive material (preferably polysilicon) is provided within second voids 37 of the first and second contact openings to a thickness which less than completely fills the voids, thereby leaving outwardly open third voids 39 within the first and second contact openings.

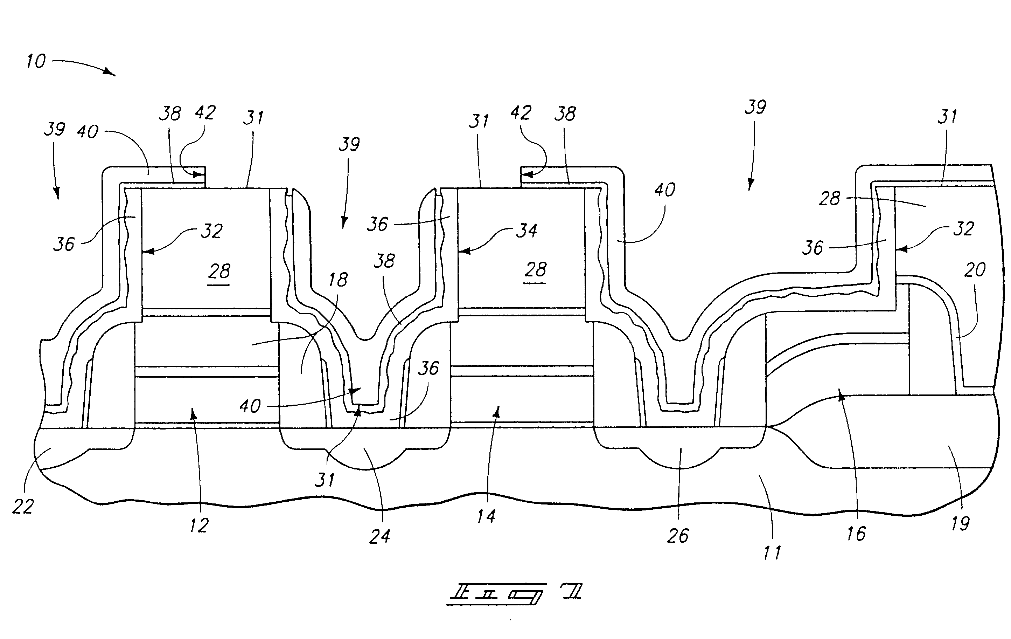

Referring to Fig. 7, cell polysilicon layer 40 and underlying cell dielectric layer 38 are patterned and etched to define the desired configuration of cell poly layer 40 for capacitor and interconnecting line construction, and to outwardly expose first electrically conductive material layer 36 within second contact opening 34. This effectively defines a contact opening 42 which is larger than and encapsulates all of second contact opening 34. Thus, all electrically conductive material within first contact openings 32 is electrically isolated from ohmic contact from all electrically conducted material within second contact openings 34. The Fig. 7 etch is conducted to etch polysilicon selectively relative to oxide initially, followed by etching of the oxide/nitride oxide selectively relative to polysilicon. Modification of the upper profile of layers 36, 38 and 40 at the top of second contact opening 34 will be produced as shown.

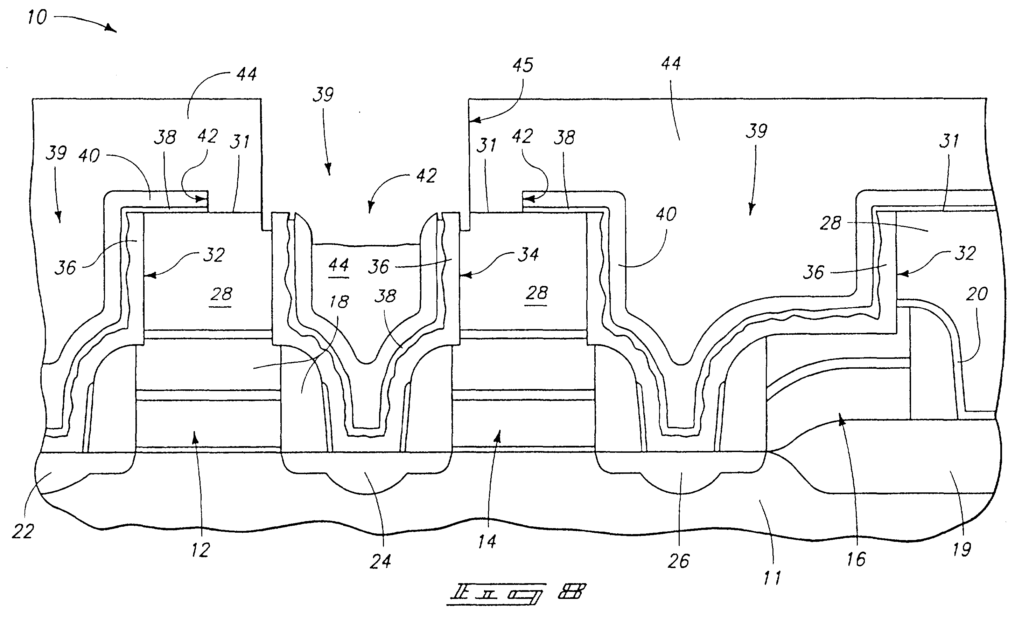

Referring to Fig. 8, a bit line insulating layer 44 (e.g., BPSG) is provided outwardly of second electrically conductive material layer 40 and to within third voids 39. A bit contact opening 45 is patterned through bit line insulating layer 40 to again outwardly expose electrically conductive first layer material 36 within second contact opening 34.

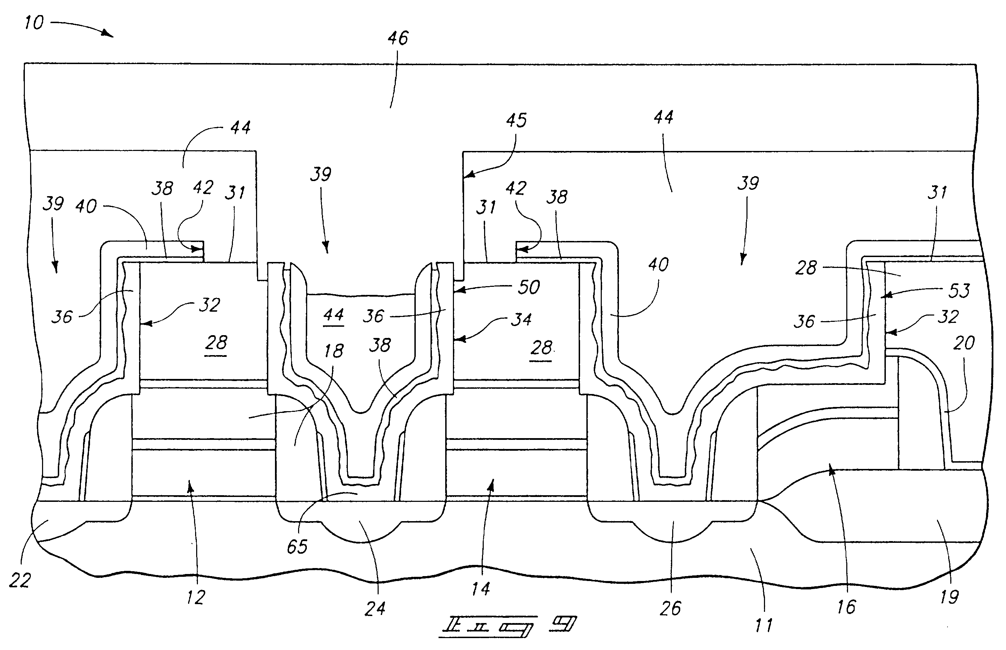

Referring to Fig. 9, a patterned bit line 46 is provided in electrical communication with the outwardly exposed electrically conductive first material layer 36 within second contact opening 34 through bit contact opening 45.

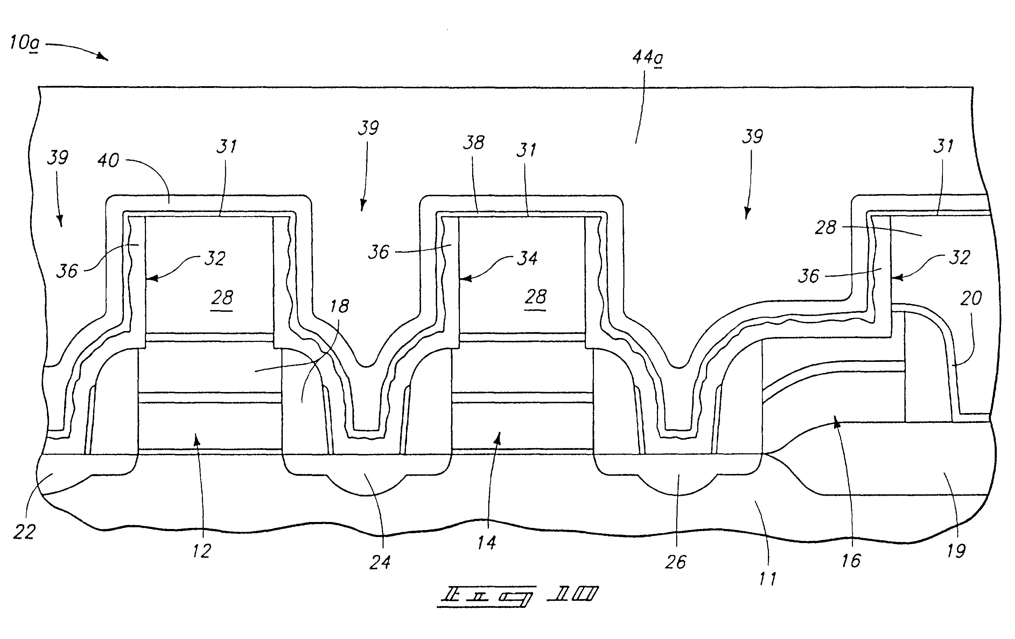

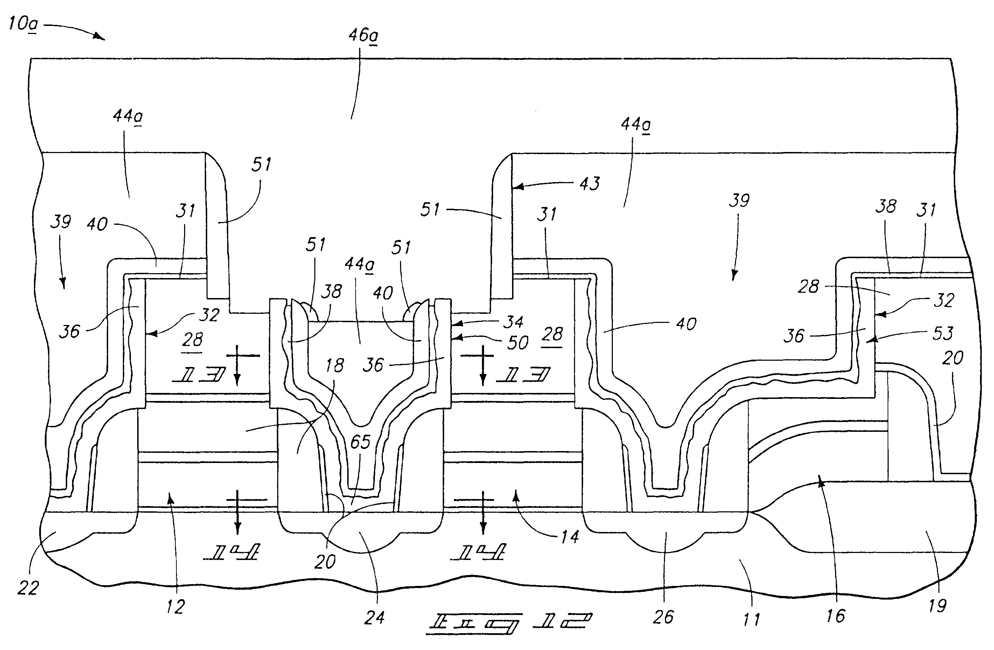

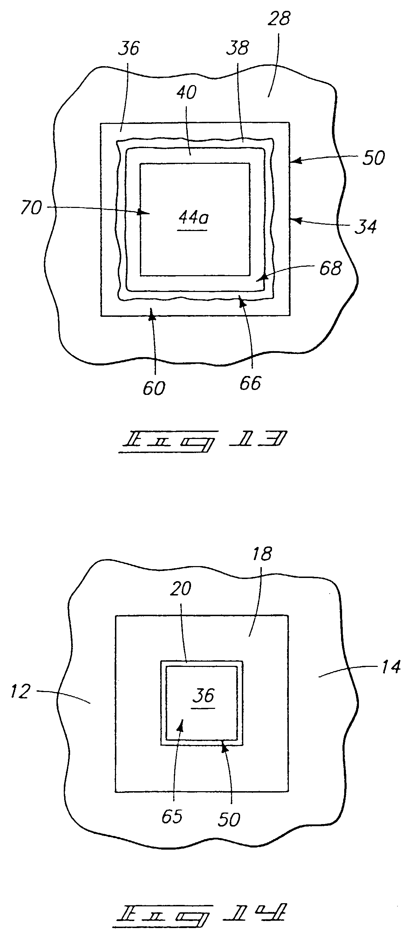

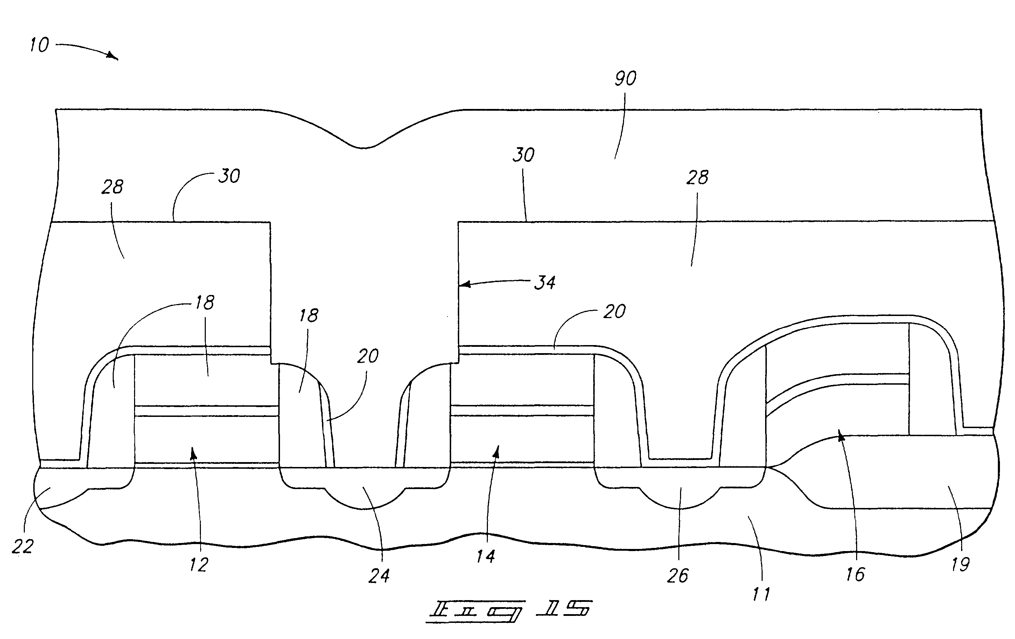

The above described process etches capacitor dielectric layer 38 and second conductive layer 40 away from over second contact opening 34 prior to provision of bit line insulating layer 44. An alternate process wherein such etching is conducted after provision of bit line insulating layer 44 is described with reference to Figs. 10-14. Fig. 10 illustrates the Fig. 6 wafer at a processing step immediately subsequent to Fig. 6 which differs from that shown in Fig. 7. Like numbers are utilized from the first described embodiment where appropriate, with significant differences being indicated by addition of a suffix "a" to the Figs. 10-14 embodiment. Fig. 10 shows fragment 10a having bit line insulating layer 44a deposited atop previously un-patterned layers 40 and 38.

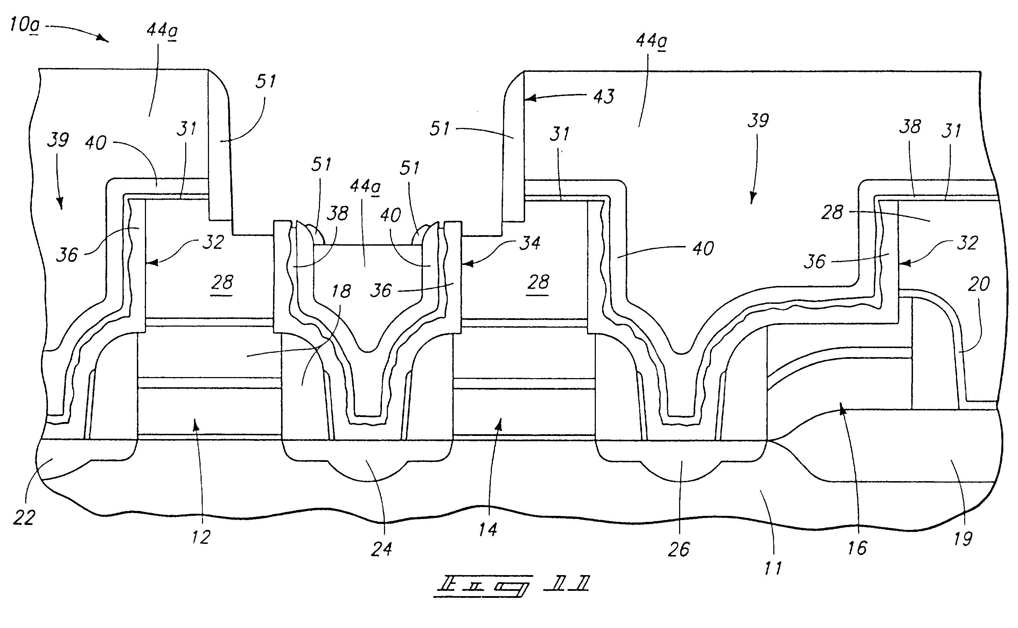

Referring to Fig. 11, layer 44a is patterned and etched to provide a bit contact opening 43 over plugged second contact opening 34. A dielectric film is deposited and anisotropically etched to provide sidewall spacers 51. Referring to Figs. 12-14, a patterned bit line layer 46a is provided. Spacers 51 electrically isolate film 40 within contact opening 32 from film 46a within bit contact opening 43.

The Figs. 10-14 process in comparison with the first described embodiment, while having the advantage of reduced masking steps, does have the disadvantage of providing greater parasitic capacitance between the bit line plugging material within contact opening 43 the result of closer proximity of such material to second cell poly layer 40 than in the first described embodiment.

Regardless of the above techniques, the process results in definition of a bit line plug 50 (Figs. 9, 12 and 13) Within second contact opening 34, and a novel semiconductor memory device. Such is comprised, by way of example, of field effect transistor gate 14 and opposing active areas 24 and 26 (Figs. 9 and 12). A capacitor 53 electrically connects with the one active area 26. A bit line 46/46a electrically connects with the other active area 24 through bit line plug 50, which extends through intermediate dielectric insulating layer 44/44a. Referring principally to Fig. 13, bit plug 50 comprises an electrically conductive annular ring 60 which is defined or formed of conductive material layer 36 within second contact opening 34. Bit line plug 50 comprises a non-annular solid mass bass plug 65 (Figs. 9, 12 and 14) which electrically connects with active area 24. Electrically conductive annular ring 60 is integral with and extends outwardly of base plug 65 the result of both constituting or resulting from conductive layer 36 deposition.

Layer 38 material comprises an electrically insulating annular ring 66 (Fig. 13) which is positioned radially inward of electrically conductive annular ring 60. Likewise, layer 40 comprises an inner electrically conductive annular ring 68 (Fig. 13) positioned radially inward of electrically insulating annular ring 66. Finally, material 44a comprises a non-annular substantially solid mass inner electrically insulating plug 70 (Fig. 13) which is provided radially inward of inner electrically conductive annular ring 68.

Accordingly in the above-described preferred embodiments, electrically conductive annular ring 60 is that portion of bit plug 50 which effectively provides electrical communication between active area 24 and bit line 46/46a. Conductive material 40 of inner electrically conductive annular ring 68 is isolated from ohmic electric connection with ring 60 the result of intervening dielectric layer 38. Despite the reduced contact area at the outer portion of a bit line plug, resistive loss of the poly has been calculated to be less than 600 ohms.

Although the immediately above-described construction was relative to a semiconductor memory device, aspects of the invention are believed to have application to other integrated circuit art areas having active areas formed relative to a semiconductor substrate where electrical connection is desired to an elevationally higher electrically conductive line. Aspects of the construction are also believed to be applicable to other integrated circuitry where elevationally inner and outer discrete electrically conductive nodes are desired to be interconnected in ohmic electrical connection.

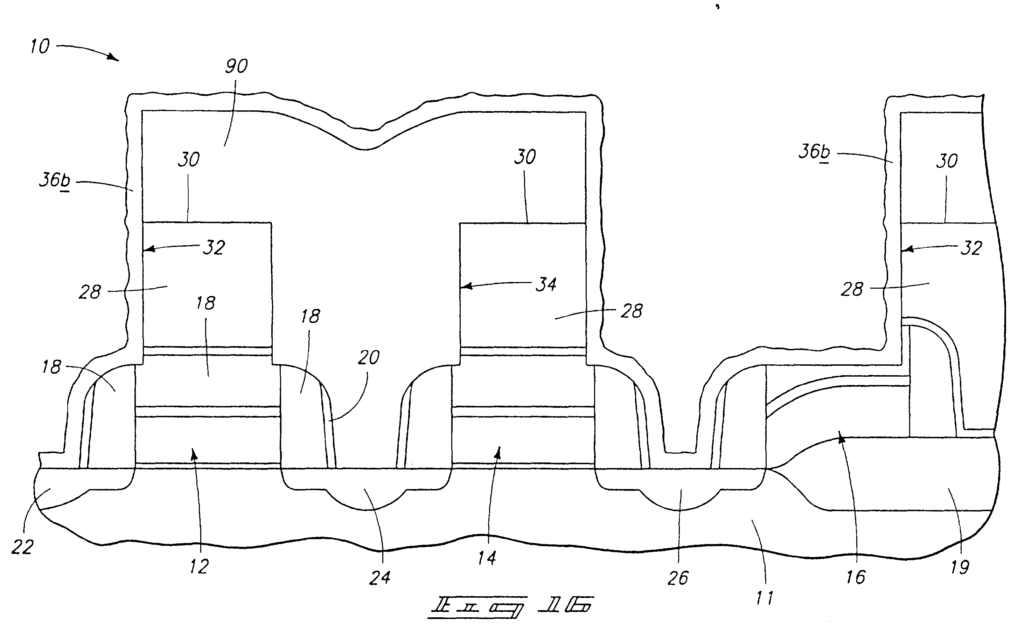

The above described processes fill both the first contact openings 32 and the second contact openings 34 with layers of conductive material and dielectric material. An alternate process wherein the first contact openings are filled with layers of conductive material and dielectric material and wherein the second contact openings are filled with only a conductive layer is described with reference to Figs. 15-18. Fig. 15 illustrates the Fig. 1 wafer at a processing step immediately subsequent to Fig. 1 which differs from that shown in Fig. 2. Like numbers are utilized from the previous described embodiments where appropriate, with significant differences being indicated by addition of a suffix "b" to the Figs. 15-18 embodiment.

Referring to Fig. 15, a series of second contact openings 34 is provided through insulating material layer 28 inwardly to outwardly expose second active region 24. Such would typically be formed, as described above, by photomasking and dry chemical etching of BPSG selectively relative to nitride and thereafter by etching nitride layer 20 selectively relative to underlying silicon substrate 11.

Subsequently, an electrically conductive layer 90 is provided over insulating material layer 28, upper surface 30 and within second contact opening 34 to electrically connect with second active region 24. Conductive layer 90 is deposited to a thickness sufficient to completely fill second contact opening 34, as shown. An example preferred composition for the material of layer 90 is conductively doped polysilicon.

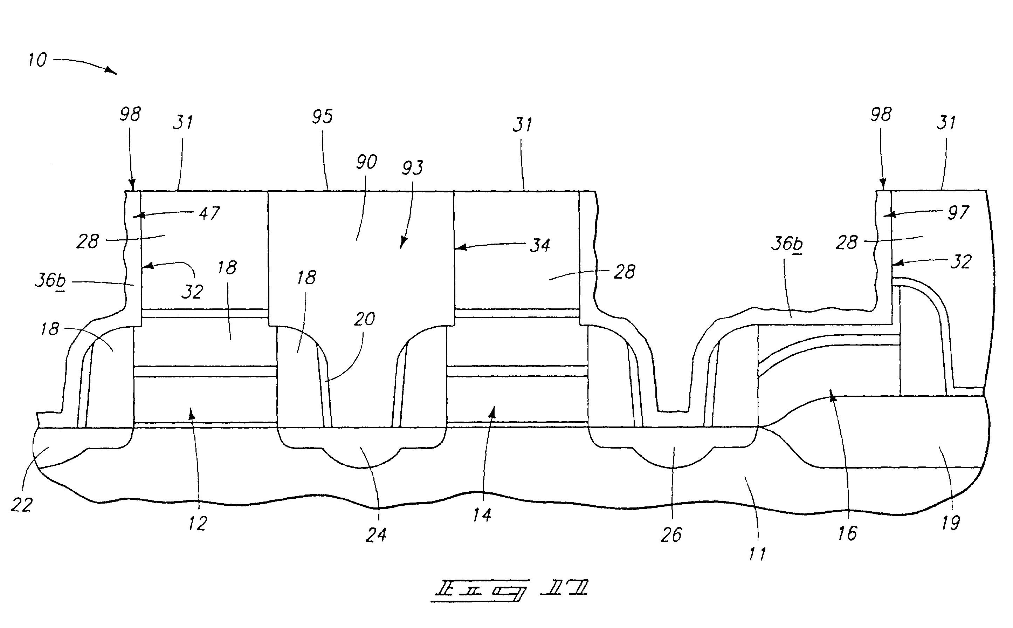

Referring to Fig. 16, a series of first contact openings 32 is provided through electrically conductive layer 90 and insulating material layer 28 inwardly to outwardly expose first active region 26. Subsequently, a capacitor storage node electrically conductive layer 36b is provided over first electrically conductive layer 90 and within first contact opening 32 to electrically connect with first active region 26. Layer 36b is deposited to a thickness which less than completely fills first contact opening 32. Example dimensions for first contact opening 32 are 0.5 micron by 0.8 micron, while an example diameter for second contact opening 34 is 0.5 micron. In such instance, an example preferred thickness for layer 90 is 4000 Angstroms. An example and preferred material for layer 36b is hemispherical grain (HSG) polysilicon. Such can be provided by first depositing a 600 Angstroms thick *in situ* doped polysilicon layer, followed by deposition of undoped HSG poly. Subsequent heating inherent in wafer processing will effectively conductively dope the overlying HSG poly layer. Alternately, layer 36b can be provided by *in situ* arsenic doping of an entire HSG layer. Layer 36b is provided to physically contact active area 26 without there being any intervening conductive layer.

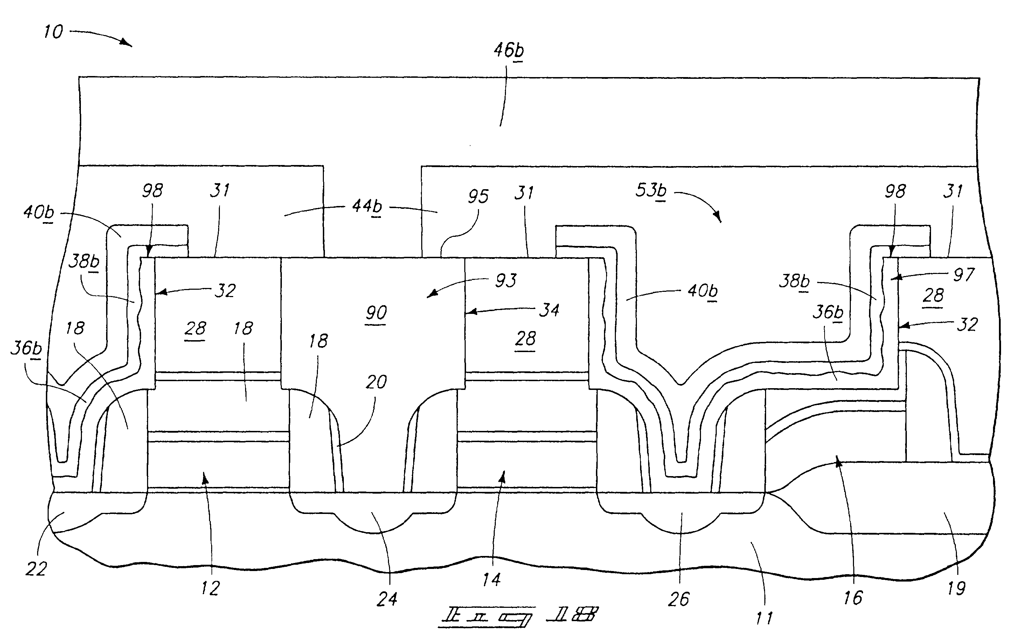

Referring to Fig. 17, capacitor storage node layer 36b and first conductive layer 90 are chemically mechanically polished inwardly to at least upper surface 30 (shown in Fig. 16) of insulating material layer 28. In the illustrated and preferred embodiment, such chemical-mechanical polishing removes first conductive layer 90 and capacitor storage node layer 36b downwardly to below former upper surface 30 of insulating material 28, which is newly designated with numeral 31. In the illustrated embodiment, such polishing is conducted to remove such materials to downwardly below the former upper surface of insulating material 31. Preferably, the chemical-mechanical polishing is conducted in a single step. An example and preferred chemical-mechanical polishing step to achieve the Fig. 17 construction includes using slurry SC25 from Rodel Products Corporation of Newark, DE, diluted with H₂O and KOH. SC25 consists primarily of H₂O, silica (SiO₂ particles), and KOH. It is diluted approximately 1:1 with H₂O and additional KOH can be injected at the point of use to increase the pH and adjust the oxide to silicon etch rate if desired.

The chemical-mechanical polishing step effectively electrically isolates first conductive layer material 90 within second contact opening 34 from storage node conductive layer material 36b within first contact opening 32. The chemical-mechanical polishing step also effectively defines a homogenous second contact plug 93 having a plug upper surface 95. Also, the chemical-mechanical polishing step effectively defines an isolated capacitor storage node 97 having an upper surface 98, with upper surface 98 of the storage node being elevationally coincident with upper surface 95 of plug 93, and correspondingly with upper surface 31 of insulating material layer 28.

Referring to Fig. 18, an ONO cell dielectric layer 38b and overlying outer second layer of conductive material 40b are provided to provide a capacitor construction 53b. As shown, capacitor construction 53b includes an inner storage node 36b, a capacitor dielectric layer 38b and outer cell node 40b. An overlying insulating layer 44b is then provided, followed by subsequent deposition and patterning of a conductive material to form a bit line 46b. A homogenous electrically conductive bit line plug is thereby provided between active area 24 and the elevation of planarized surface 31, and therefore between active area 24 and the elevation of inner storage node 97 upper surface 98.

## Claims

1. A method of forming a capacitor opening, comprising the following steps:
forming an electrically conductive layer over an insulating material layer; and forming a capacitor opening through the electrically conductive layer and into the insulating material layer.

2. The method of claim 1 further comprising:
after forming the capacitor opening, removing the electrically conductive layer from over the insulating material layer.

3. The method of claim 1 further comprising:
after forming the capacitor opening, polishing the electrically conductive layer to remove the electrically conductive layer from over the insulating material layer.

4. The method of claim 1 further comprising:
after forming the capacitor opening, chemical-mechanical polishing the electrically conductive layer to remove the electrically conductive layer from over the insulating material layer.

5. The method of claim 1 further comprising:
forming a bit line contact opening within the insulating material layer; and forming the electrically conductive layer over the insulating material layer and within the bit line contact opening, the electrically conductive layer within the bit line contact opening ultimately forming a bit line plug.

6. The method of claim 1 further comprising:
forming a word line over a semiconductor wafer;
forming a first active region and a second active region associated with the word line;
forming the electrically insulating material layer over the word line and active regions; forming a bit line contact opening through the insulating material layer to the second active region;
forming the electrically conductive layer over the insulating material layer and within the bit line contact opening, the electrically conductive layer within the bit line contact opening ultimately forming a bit line plug; and
forming a capacitor opening through the electrically conductive layer and through the insulating material to the first active region.

7. The method of claim 6 wherein the layer of electrically insulating material comprises an upper surface at a first level, the method further comprising removing the electrically conductive layer to below the first level of the upper surface of the layer of the insulating material.

8. The method of claim 6 wherein the layer of electrically insulating material comprises an upper surface at a first level, the method further comprising chemical-mechanical polishing the electrically conductive layer to below the first level of the upper surface of the layer of the insulating material.

9. The method of claim 1 further comprising:
forming an array of word lines over a semiconductor wafer;
forming first and second active regions associated with each of the word lines;
forming the electrically insulating material layer over the word lines and active regions;
forming bit line contact openings through the insulating material layer to the second active regions;
forming the electrically conductive layer over the insulating material layer and within the bit line contact openings, the electrically conductive layer within the bit line contact openings ultimately forming bit line plugs; and
forming the capacitor opening as one of several capacitor openings formed through the electrically conductive layer and through the insulating material to the first active regions.

10. The method of claim 9 wherein the layer of electrically insulating material comprises an upper surface at a first level, the method further comprising removing the electrically conductive layer to below the first level of the upper surface of the layer of the insulating material.

11. The method of claim 9 wherein the layer of electrically insulating material comprises an upper surface at a first level, the method further comprising chemical-mechanical polishing the electrically conductive layer to below the first level of the upper surface of the layer of the insulating material.

12. The method of claim 1 further comprising:
forming an array of word lines over a semiconductor wafer;
forming active areas associated with the word lines to define an array of memory cell FETs, the active areas being defined by a first active region for electrical connection with a memory cell capacitor and a second active region for electrical connection with a bit line;
forming the electrically insulating material layer over the word lines and active areas;
forming a bit line contact opening through the insulating material layer to the second active region;
forming the electrically conductive layer over the insulating material layer and within the bit line contact opening as a first electrically conductive layer;
forming the capacitor opening through the first electrically conductive layer and through the insulating material to the first active region;
forming a capacitor storage node electrically conductive layer over the first electrically conductive layer and within the capacitor opening; and
polishing the capacitor storage node layer and the first conductive layer to effectively electrically isolate the first conductive layer material within the bit line contact opening from the storage node conductive layer material within the capacitor opening, the polishing step effectively defining a bit line contact plug and a capacitor storage node.

13. The method of claim 12 wherein the polishing is conducted in a single step.

14. The method of claim 12 wherein the storage node conductive layer physically contacts the first active region.

15. The method of claim 12 wherein the storage node conductive layer physically contacts the first active region, and the polishing is conducted in a single step.

16. The method of claim 12 wherein the layer of electrically insulating material comprises an upper surface at a first level, the method further comprising removing the first conductive layer and the capacitor storage node layer downwardly to below the first level.

17. The method of claim 12 wherein the layer of electrically insulating material comprises an upper surface at a first level, the method further comprising removing the first conductive layer and the capacitor storage node layer downwardly to below the first level, and the polishing is conducted in a single step.

18. The method of claim 12 wherein the polishing comprises chemical-mechanical polishing.
